# EUROPEAN PATENT SPECIFICATION

(11) **EP 3 163 623 B1**
(45) Date of publication and mention of the grant of the patent: **05.05.2021**
(21) Application number: 16196371.5
(22) Date of filing: 28.10.2016
(51) Int. Cl.: H01L 27/32, C09B 67/02, G02B 5/20, H01L 51/52, G02B 5/22

(54) **TRANSPARENT ORGANIC LIGHT EMITTING DISPLAY DEVICE**
VORRICHTUNG MIT TRANSPARENTER ORGANISCHER LICHTEMITTIERENDER ANZEIGE
DISPOSITIF D'AFFICHAGE ÉLECTROLUMINESCENT ORGANIQUE TRANSPARENT

(30) Priority: 30.10.2015 KR 20150151494
(43) Date of publication of application: 03.05.2017
(73) Proprietor: LG Display Co., Ltd., Seoul 07336 (KR)
(72) Inventor: KIM, JongMoo, 03471 Seoul (KR); AN, Hyunjn, 10949 Gyeonggi-do (KR)
(74) Representative: Morrall, Jonathan Ian McLachlan

(56) References cited:
- EP-A1- 3 010 063
- US-A1- 2004 195 573
- US-A1- 2013 285 539
- US-A1- 2015 097 171

## Description

### BACKGROUND OF THE INVENTION

### Field of the Invention

The present invention relates to an organic light emitting display device, and more particularly, to a transparent organic light emitting display device.

### Discussion of the Related Art

Organic light emitting display devices are self-emitting devices and have characteristics such as low consumption power, a fast response time, high emission efficiency, high luminance, and a wide viewing angle. There is an attempt to manufacture transparent organic light emitting display devices by transparently implementing organic light emitting display devices. The transparent organic light emitting display devices enable users to look at both a displayed image and a rear scene simultaneously. Hereinafter, a related art transparent organic light emitting display device will be described with reference to the drawing.

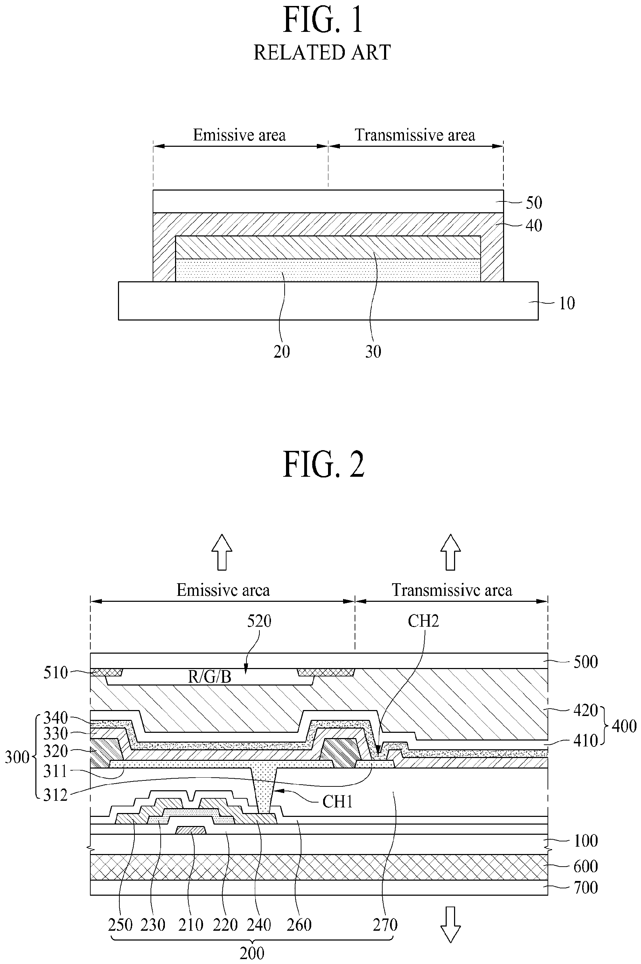

FIG. 1 is a schematic diagram of a related art transparent organic light emitting display device. As seen in FIG. 1, the related art transparent organic light emitting display device includes an emissive area and a transmissive area. The emissive area corresponds to an area where light is emitted from an organic light emitting device, and thus, an image is displayed. The transmissive area corresponds to an area which transmits external light without light being emitted, and thus, enables a user to look at a rear scene.

The emissive area and the transmissive area each includes a circuit device layer 20, an emission device layer 30, an encapsulation layer 40, and a second substrate 50 which are stacked on a first substrate 10. The circuit device layer 20 is formed on the first substrate 10. The circuit device layer 20 includes a thin film transistor (TFT) and a capacitor for controlling emission of light from the emission device layer 30, and a plurality of insulation layers for insulating conductive layers. In more detail, the TFT, the capacitor, and the plurality of insulation layers are all provided in the circuit device layer 20 in the emissive area. However, only the plurality of insulation layers are provided without the TFT and the capacitor being provided in the circuit device layer 20 in the transmissive area.

The emission device layer 30 is formed on the circuit device layer 20. The emission device layer 30 includes an anode, a cathode, and an emission layer formed between the anode and the cathode. In more detail, the anode is connected to the TFT of the circuit device layer 20 and is provided in the emissive area, but is not provided in the transmissive area. The cathode and the emission layer may be provided in all of the emissive area and the transmissive area. The encapsulation layer 40 is formed on the emission device layer 30. The encapsulation layer 40 prevents water from penetrating into the emission device layer 30. The second substrate 50 is formed on the encapsulation layer 40. The second substrate 50 protects a top of the transparent organic light emitting display device.

In the related art transparent organic light emitting display device, an image is displayed on the emissive area, and external light passes through the transmissive area, thereby enabling a viewer to look at a rear scene. Accordingly, the viewer watches an image through a transparent background.

However, in the related art transparent organic light emitting display device, a rear scene is not transparently viewed but is viewed in a yellowish state. That is, when external light passes through the transmissive area, the rear scene is changed to the yellowish state, and for this reason, there is a limitation in implementing a high-quality display device.

Document US 2013/285539 A1 discloses an organic light emitting display device which has a transparent display panel provided with a transparent area to partly transmit light incident on the first surface of the panel to the second opposite surface of the panel.

### SUMMARY OF THE INVENTION

Accordingly, the present invention is directed to provide a transparent organic light emitting display device that substantially obviates one or more problems due to limitations and disadvantages of the related art. In order to solve the above-described problems of the related art, analysis has been performed to determine a cause of that external light being changed to a yellowish state when passing through a transmissive area. A result of the analysis has shown that the external light is changed to the yellowish state due to an organic material provided in the transmissive area. However, due to a stacked structure of a transparent organic light emitting display device, it is difficult to prevent the organic material from being provided in the transmissive area.

An aspect of the present invention is directed to provide a transparent organic light emitting display device which enables a transmissive area to be seen in a transparent state instead of a yellowish state despite organic materials being stacked in the transmissive area.

Additional advantages and features of the invention will be set forth in part in the description which follows and in part will become apparent to those having ordinary skill in the art upon examination of the following or may be learned from practice of the invention. The objectives and other advantages of the invention may be realized and attained by the structure particularly pointed out in the written description and claims hereof as well as the appended drawings.

In consideration of that external light is changed to a yellowish state due to an organic material, an additional wavelength change layer is provided that changes a wavelength range of transmitted light by absorbing only light in a yellowish wavelength range, thereby enabling a transmissive area to be seen in a transparent state. Accordingly, a transparent organic light emitting display device is implemented that enables the transmissive area to be seen in the transparent state.

In particular, in order to accomplish the above-described object, a transparent organic light emitting display device according to an embodiment of the present invention is disclosed as recited in claim 1.

It is to be understood that both the foregoing general description and the following detailed description of the present invention are exemplary and explanatory and are intended to provide further explanation of the invention as claimed.

### BRIEF DESCRIPTION OF THE DRAWINGS

The accompanying drawings, which are included to provide a further understanding of the invention and are incorporated in and constitute a part of this application, illustrate embodiments of the invention and together with the description serve to explain the principle of the invention. In the drawings:
FIG. 1 is a schematic diagram of a related art transparent organic light emitting display device;
FIG. 2 is a schematic cross-sectional view of a transparent organic light emitting display device according to an embodiment of the present invention;
FIG. 3 is a schematic cross-sectional view of a transparent organic light emitting display device according to another embodiment of the present invention;
FIG. 4 is a schematic cross-sectional view of a transparent organic light emitting display device according to another embodiment of the present invention;
FIG. 5 is a schematic cross-sectional view of a transparent organic light emitting display device according to another embodiment of the present invention;
FIG. 6 is a graph showing a light transmittance of a wavelength change layer according to an embodiment of the present invention with respect to a wavelength range;
FIG. 7 is a graph showing a light transmittance of an organic light emitting display device (OLED, a comparative example) to which the wavelength change layer is not applied and a light transmittance of an OLED (an embodiment) to which the wavelength change layer is applied, with respect to a wavelength range; and
FIG. 8 is a graph showing a light transmittance based on a change in concentration of a dye constituting a light-absorbing material in the wavelength change layer.

### DETAILED DESCRIPTION OF THE EMBODIMENTS

Reference will now be made in detail to the exemplary embodiments of the present invention, examples of which are illustrated in the accompanying drawings. Wherever possible, the same reference numbers will be used throughout the drawings to refer to the same or like parts.

Advantages and features of the present invention, and implementation methods thereof will be clarified through following embodiments described with reference to the accompanying drawings. The present invention may, however, be embodied in different forms and should not be construed as limited to the embodiments set forth herein. Rather, these embodiments are provided so that this disclosure will be thorough and complete, and will fully convey the scope of the present invention to those skilled in the art. Further, the present invention is only defined by the scope of the claims.

A shape, a size, a ratio, an angle, and a number disclosed in the drawings for describing embodiments of the present invention are merely an example, and thus, the present invention is not limited to the illustrated details. Like reference numerals refer to like elements throughout. In the following description, when the detailed description of the relevant known function or configuration is determined to unnecessarily obscure the important point of the present invention, the detailed description will be omitted. In a case where 'comprise', 'have', and 'include' described in the present specification are used, another part may be added unless 'only∼' is used. The terms of a singular form may include plural forms unless referred to the contrary.

In construing an element, the element is construed as including an error range although there is no explicit description.

In describing a position relationship, for example, when a position relation between two parts is described as 'on∼', 'over∼', 'under∼', and 'next∼', one or more other parts may be disposed between the two parts unless 'just' or 'direct' is used.

In describing a time relationship, for example, when the temporal order is described as 'after∼', 'subsequent∼', 'next∼', and 'before∼', a case which is not continuous may be included unless 'just' or 'direct' is used.

It will be understood that, although the terms "first", "second", etc. may be used herein to describe various elements, these elements should not be limited by these terms. These terms are only used to distinguish one element from another. For example, a first element could be termed a second element, and, similarly, a second element could be termed a first element, without departing from the scope of the present invention.

Features of various embodiments of the present invention may be partially or overall coupled to or combined with each other, and may be variously inter-operated with each other and driven technically as those skilled in the art can sufficiently understand. The embodiments of the present invention may be carried out independently from each other, or may be carried out together in co-dependent relationship.

Hereinafter, embodiments of the present invention will be described in detail with reference to the accompanying drawings.

FIG. 2 is a schematic cross-sectional view of a transparent organic light emitting display device according to an embodiment of the present invention. As seen in FIG. 2, the transparent organic light emitting display device according to an embodiment of the present invention includes an emissive area and a transmissive area. The emissive area corresponds to an area which emits light to display an image. The transmissive area corresponds to an area which transmits external light without light being emitted, and thus, enables a user to look at a rear scene.

The emissive area and the transmissive area may each include a first substrate 100, a circuit device layer 200, an emission device layer 300, an encapsulation layer 400, a second substrate 500, a wavelength change layer 600, and a protection substrate 700. The first substrate 100 may be formed of glass or transparent plastic. The circuit device layer 200 is formed on a top of the first substrate 100. The circuit device layer 200 may include a gate electrode 210, a gate insulation layer 220, a semiconductor layer 230, a source electrode 240, a drain electrode 250, a passivation layer 260, and a planarization layer 270.

The gate electrode 210 may be formed on the top of the first substrate 100. The gate insulation layer 220 may be formed on a top of the gate electrode 210 and may insulate the gate electrode 210 from the semiconductor layer 230. The semiconductor layer 230 may be formed of a silicon-based semiconductor material, an oxide-based semiconductor material, and/or the like. The source electrode 240 and the drain electrode 250 may be spaced apart from each other over a top of the semiconductor layer 230. The passivation layer 260 may be formed on a top of each of the source electrode 240 and the drain electrode 250 and may protect a thin film transistor (TFT). The planarization layer 270 may be formed on a top of the passivation layer 260. In the drawing, a bottom gate structure where the gate electrode 210 is disposed under the semiconductor layer 230 is illustrated, but the present embodiment is not limited thereto. In other embodiments, the transparent organic light emitting display device may be implemented in a top gate structure where the gate electrode 210 is disposed over the semiconductor layer 230.

The gate electrode 210, the semiconductor layer 230, the source electrode 240, and the drain electrode 250 which configure the TFT may be disposed in the emissive area, but may not be disposed in the transmissive area. The gate insulation layer 220, the passivation layer 260, and the planarization layer 270 may be disposed in the emissive area and the transmissive area in common.

Since the gate insulation layer 220 and the passivation layer 260 are generally formed of silicon oxide (SiOx) or silicon nitride (SiNx), the gate insulation layer 220 and the passivation layer 260 barely affect to change external light which passes through the transmissive area into a yellowish state. A yellowish state may be considered to be a yellow or yellow-tinted state, in other words a state that appears yellow. On the other hand, since the planarization layer 270 is generally formed of an organic material such as acryl resin, epoxy resin, phenolic resin, polyamide resin, polyimide resin, or the like, the planarization layer 270 greatly affects to change the external light which passes through the transmissive area into the yellowish state.

The emission device layer 300 is formed on a top of the circuit device layer 200. The emission device layer 300 may include a first electrode 311, an auxiliary electrode 312, a bank layer 320, an emission part 330, and a second electrode 340.

The first electrode 311 may be formed on a top of the planarization layer 270. The first electrode 311 may act as an anode. The first electrode 311 may be pattern-formed in each of a plurality of pixels, and thus, the first electrode 311 may be disposed in the emissive area but may not be disposed in the transmissive area. The first electrode 311 may be connected to the source electrode 240 through a first contact hole CH1 which is included in the passivation layer 260 and the planarization layer 270. That is, the source electrode 240 may be exposed by the first contact hole CHI, and thus, the first electrode 311 may be connected to the source electrode 240 through the first contact hole CH1. Depending on the case, the first contact hole CH1 may be formed to expose the drain electrode 250, and thus, the first electrode 311 may be connected to the drain electrode 250.

Likewise with the first electrode 311, the auxiliary electrode 312 may be formed on the top of the planarization layer 270. The auxiliary electrode 312 may be electrically insulated from the first electrode 311. The auxiliary electrode 312 may be connected to the second electrode 340 capable of acting as a cathode and may lower a resistance of the second electrode 340. According to an embodiment of the present invention, the transparent organic light emitting display device may be a top emission type where light emitted from the emission part 330 is transferred in an up direction toward the second substrate 500. Therefore, since the light emitted from the emission part 330 should pass through the second electrode 340, a material of the second electrode 340 may use a transparent conductive material such as metal oxide or the like. However, the transparent conductive material such as metal oxide is high in resistance. Accordingly, the auxiliary electrode 312 may be electrically connected to the second electrode 340, thereby lowering the resistance of the second electrode 340. The auxiliary electrode 312 may be disposed in the transmissive area or the emissive area.

The bank layer 320 may be formed on the top of each of the first electrode 311 and the auxiliary electrode 312. The bank layer 320 may be pattern-formed in order for a portion of the top of the first electrode 311 to be exposed, thereby securing an area where an image is displayed. Also, the bank layer 320 may be formed between the first electrode 311 and the auxiliary electrode 312 and may insulate the first electrode 311 from the auxiliary electrode 312. The bank layer 320 may be disposed in the emissive area but may not be disposed in the transmissive area. However, the bank layer 320 is not limited thereto, and in other embodiments, the bank layer 320 may be disposed in the transmissive area. The bank layer 320 may be formed of an organic material such as polyimide resin, acryl resin, benzocyclobutene (BCB), or the like, and thus, if the bank layer 320 is disposed in the transmissive area, the bank layer 320 greatly affects to change the external light which passes through the transmissive area into the yellowish state.

The emission part 330 may be formed on the top of the first electrode 311. The emission part 330 may include a hole injecting layer, a hole transporting layer, an emission layer, an electron transporting layer, and an electron injecting layer. A structure of the emission part 330 may be modified to various types well known to those skilled in the art. White light may be emitted from the emission layer, and thus, white light may be emitted from the emission part 330. The emission part 330 may be disposed in the emissive area and the transmissive area in common. A second contact hole CH2 may be formed in the emission part 330 in order for the auxiliary electrode 312 to be connected to the second electrode 340. That is, the auxiliary electrode 312 may be exposed by the second contact hole CH2, and thus, the second electrode 340 may be electrically connected to the auxiliary electrode 312 through the second contact hole CH2. Since the emission part 330 is formed of an organic material, the emission part 330 greatly affects to change the external light which passes through the transmissive area into the yellowish state.

The second electrode 340 may be formed on the top of the emission part 330. The second electrode 340 may act as a cathode. The second electrode 340 may be electrically connected to the auxiliary electrode 312 through the second contact hole CH2. An electrical connection between the second electrode 340 and the auxiliary electrode 312 may be established by various methods, well known to those skilled in the art, such as a method based on a reversely-tapered eave structure. The second electrode 340 may be disposed in the emissive area and the transmissive area in common.

The encapsulation layer 400 is formed on the top of the emission device layer 300. The encapsulation layer 400 prevents water from penetrating into the emission device layer 300. The encapsulation layer 400 may include a passivation layer 410 and a filling layer 420. The passivation layer 410 may be formed on the top of the emission device layer 300, and the filling layer 420 may be formed on a top of the passivation layer 410. The filling layer 420 may be formed of a material having adhesive characteristic.

The second substrate 500 is formed on the top of the encapsulation layer 400. A black matrix 510 and a color filter layer 520 may be formed on a bottom of the second substrate 500. The black matrix 510 may be pattern-formed to define a pixel area. The color filter layer 520 may be disposed in the pixel area defined by the black matrix 510. The color filter layer 520 may include a red (R) color filter, a green (G) color filter, and a blue (B) color filter which are pattern-formed in respective pixels. According to an embodiment of the present invention, since the white light is emitted from the emission part 330, the color filter layer 520 may be additionally pattern-formed in each pixel, and thus, a color image may be displayed.

The wavelength change layer 600 is formed on a bottom of the first substrate 100. The wavelength change layer 600 prevents the external light, passing through the transmissive area, from being changed to the yellowish state. Since organic materials such as the planarization layer 270, the bank layer 320, and the emission part 330 are stacked in the transmissive area, the external light is changed to the yellowish state by the organic materials. For this reason, according to an embodiment of the present invention, since the wavelength change layer 600 is disposed on the bottom of the first substrate 100, the external light passing through the transmissive area may be put in a transparent state. A transparent state is a state that does not exhibit an apparent color change in transmitted light (i.e. color tinting of the transparent light is not evident). To this end, the wavelength change layer 600 comprises a light-absorbing material that absorbs light in a yellowish wavelength range. A light-absorbing material that absorbs light in a particular range may also be described as a material that preferentially absorbs light in that range relative to other ranges. That is, despite the external light being changed to the yellowish state by the organic materials, since the light in the yellowish wavelength range is absorbed by the light-absorbing material included in the wavelength change layer 600, the external light may be transmitted in the transparent state.

In a case where light is transmitted in a down direction with respect to the wavelength change layer 600, when the external light changed to the yellowish state due to the organic materials is irradiated on the wavelength change layer 600, the wavelength change layer 600 may absorb the light in the yellowish wavelength range, and thus, light passing through the wavelength change layer 600 may be changed from the yellowish state to the transparent state and output. Also, in a case where the light is transmitted in an up direction with respect to the second substrate 500, since the light in the yellowish wavelength range is absorbed by the wavelength change layer 600 and then passes through the organic materials, the light in the yellowish wavelength range may increase while passing through the organic materials, and thus, light having the transparent state may be output.

The wavelength change layer 600 comprises a light-absorbing material that absorbs light in a wavelength range of 500 nm to 680 nm, in order for light having the transparent state to pass through the transmissive area. In detail, the wavelength change layer 600 may include transparent resin and the light-absorbing material that absorbs the light in the wavelength range of 500 nm to 680 nm.

The transparent resin may act as a binder of the light-absorbing material. Also, the transparent resin may have an adhesive force. The transparent resin having an adhesive force enables the wavelength change layer 600 to be adhered to the bottom of the first substrate 100. Also, the transparent resin having an adhesive force enables the protection substrate 700 to be adhered to the wavelength change layer 600. Accordingly, the protection substrate 700 may be adhered to the wavelength change layer 600 without a separate adhesive.

The light-absorbing material that absorbs the light in the wavelength range of 500 nm to 680 nm may include a dye that includes chromophore and auxochrome. The dye may absorb the light in the wavelength range of 500 nm to 680 nm to have a bluish color. Therefore, the external light changed to the yellowish state may be changed to the transparent state by the dye having a bluish color. A bluish state may be considered to be a blue or blue-tinted state, in other words a state that appears blue.

The chromophore may be used to produce a color and may include a conjugation structure where a single bond and a double bond are alternately arranged, and particularly, may include benzene. The auxochrome may be linked to the chromophore and may be used to shift a color spectrum to produce a desired color. The auxochrome may include an amino group, a hydroxyl group, or an alkyl group, in order for the dye to be well mixed with the transparent resin.

The dye, which includes the chromophore and the auxochrome and absorbs the light in the wavelength range of 500 nm to 680 nm, may include a compound represented by the following Formula 1.

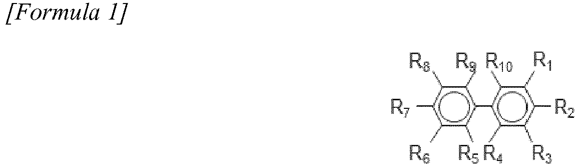

In Formula 1, R₁ to R₁₀ may each be independently selected from the group consisting of hydrogen (H), an alkyl group, a cycloalkyl group, a polycycloalkyl group, a heterocycloalkyl group, an aryl group, an alkaryl group, an aralkyl group, an alkoxy group, an alkenyl group, a hydroxyl group, an amino group, and an alkynyl group. The alkyl group, the cycloalkyl group, the polycycloalkyl group, the heterocycloalkyl group, the aryl group, the alkaryl group, the aralkyl group, the alkoxy group, the alkenyl group, the hydroxyl group, the amino group, and the alkynyl group may each include one to fifty carbon atoms, and the carbon may include at least one linking group selected from the group consisting of halogen, nitrogen, oxygen, alcohols, ester, ammonium salts, and phosphonium salts.

The dye, which includes the chromophore and the auxochrome and absorbs the light in the wavelength range of 500 nm to 680 nm, may include a compound represented by the following Formula 2.

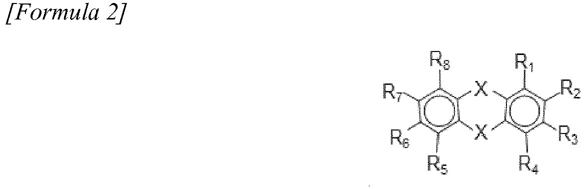

In Formula 2, X may consist of N-R₉, O, or S. In Formula 2, R₁ to R₉ may each be independently selected from the group consisting of hydrogen (H), an alkyl group, a cycloalkyl group, a polycycloalkyl group, a heterocycloalkyl group, an aryl group, an alkaryl group, an aralkyl group, an alkoxy group, an alkenyl group, a hydroxyl group, an amino group, and an alkynyl group.

The alkyl group, the cycloalkyl group, the polycycloalkyl group, the heterocycloalkyl group, the aryl group, the alkaryl group, the aralkyl group, the alkoxy group, the alkenyl group, the hydroxyl group, the amino group, and the alkynyl group may each include one to fifty carbon atoms, and the carbon may include at least one linking group selected from the group consisting of halogen, nitrogen, oxygen, alcohols, ester, ammonium salts, and phosphonium salts.

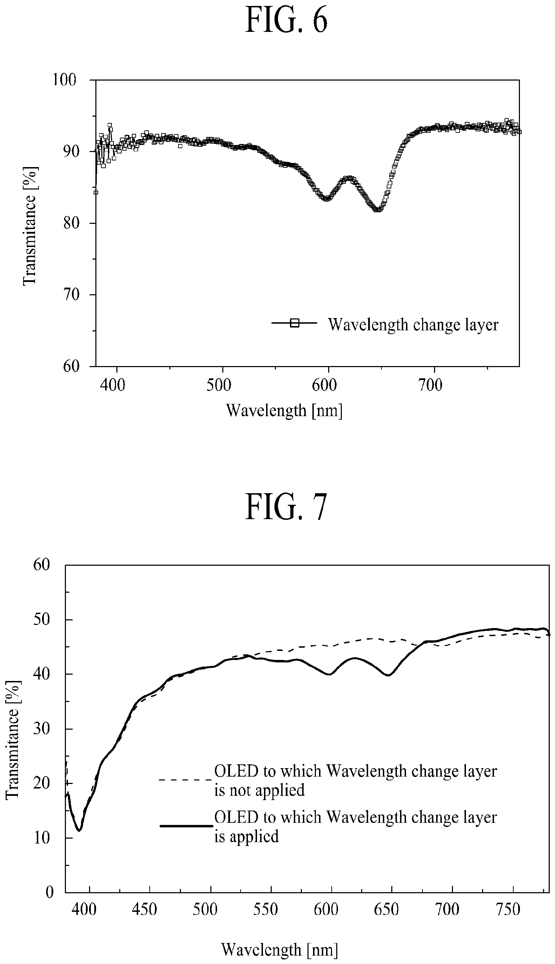

FIG. 6 is a graph showing a light transmittance of the wavelength change layer 600 according to an embodiment of the present invention with respect to a wavelength range. As seen in FIG. 6, according to an embodiment of the present invention, it can be seen that a light transmittance is reduced within a wavelength range of 500 nm to 680 nm. This is because the wavelength change layer 600, as described above, includes the dye that absorbs light in the wavelength range of 500 nm to 680 nm.

FIG. 7 is a graph showing a light transmittance of an organic light emitting display device (OLED, a comparative example) to which the wavelength change layer 600 is not applied and a light transmittance of an OLED (an embodiment of the present invention) to which the wavelength change layer 600 is applied, with respect to a wavelength range in the transparent organic light emitting display device having the structure illustrated in FIG. 2.

As seen in FIG. 7, it can be seen that in a wavelength range of 500 nm to 680 nm, a light transmittance is further reduced in the OLED (the embodiment), to which the wavelength change layer 600 is applied, than the OLED (the comparative example) to which the wavelength change layer 600 is not applied. Also, it can be seen that in a wavelength range of less than 500 nm and more than 680 nm, a light transmittance of the embodiment is similar to that of the comparative example.

As a result, in the comparative example to which the wavelength change layer 600 is not applied, a light transmittance is relatively high in the wavelength range of 500 nm to 680 nm, and thus, yellowish light is emitted. In the embodiment to which the wavelength change layer 600 is applied, a light transmittance is relatively low in the wavelength range of 500 nm to 680 nm, and thus, transparent light is emitted.

The wavelength change layer 600 may be formed to have a thickness within a range of 30 µm to 500 µm. If a thickness of the wavelength change layer 600 is less than 30 µm or more than 500 µm, a color conversion effect is small or excessive, and for this reason, it is unable to obtain external light which is transparent in the transmissive area. The dye constituting the light-absorbing material in the wavelength change layer 600 may be provided at a concentration of 100 ppm to 5000 ppm, for example, 300 ppm to 1000 ppm.

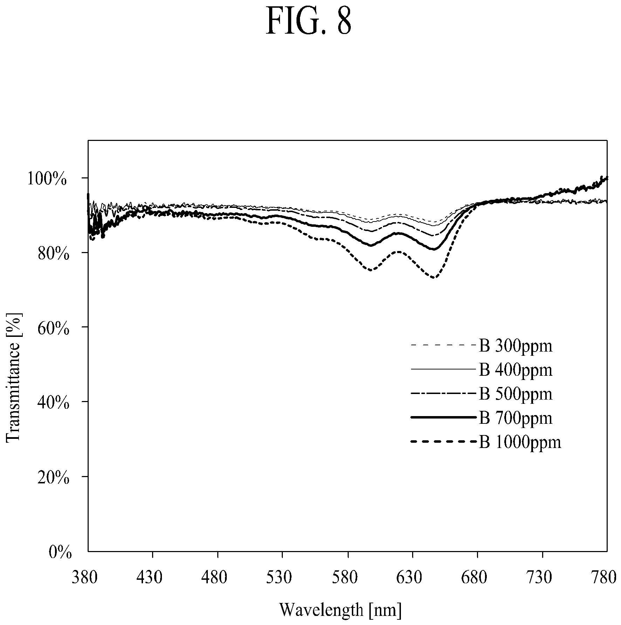

FIG. 8 is a graph showing a light transmittance based on a change in concentration of the dye constituting the light-absorbing material in the wavelength change layer 600. As seen in FIG. 8, it can be seen that as a concentration B of the dye increases from 300 ppm to 1000 ppm, a light transmittance is progressively reduced in a wavelength range of 500 nm to 680 nm. That is, as the concentration B of the dye increases, a light transmittance is progressively reduced in the wavelength range of 500 nm to 680 nm. Considering this, the concentration of the dye is within 100 ppm to 5000 ppm, preferably, 300 ppm to 1000 ppm.

Referring again to FIG. 2, since the wavelength change layer 600 enables the external light to be transparently output in the transmissive area, the wavelength change layer 600 may be disposed in the transmissive area without being disposed in the emissive area. If the wavelength change layer 600 is not disposed in the emissive area, a step height occurs, and for this reason, in order to prevent occurrence of the step height, the wavelength change layer 600 may be disposed in the emissive area and the transmissive area in common. That is, the wavelength change layer 600 may be disposed all over the bottom of the first substrate 100. Moreover, the wavelength change layer 600 acts as an adhesive layer for attaching the protection substrate 700 on the wavelength change layer 600, and thus, when the wavelength change layer 600 is disposed in the emissive area and the transmissive area in common, the protection substrate 700 may be adhered to the wavelength change layer 600 without a separate additional process.

In FIG. 2, the wavelength change layer 600 is disclosed as being disposed on the bottom of the first substrate 100, but is not limited thereto. In other embodiments, the wavelength change layer 600 may be disposed on the top of the second substrate 500. However, if the wavelength change layer 600 is disposed on the top of the second substrate 500, image quality is degraded due to the wavelength change layer 600 when displaying an image on the emissive area. Therefore, the wavelength change layer 600 may be disposed on a surface (i.e., a surface opposite to a display surface displaying an image) opposite to a surface from which light is emitted in the emissive area. That is, the wavelength change layer 600 may be disposed on the bottom of the first substrate 100 corresponding to the surface opposite to the display surface displaying an image.

The protection substrate 700 may be disposed on a bottom of the wavelength change layer 600. The protection substrate 700 may be adhered to the transparent resin in the wavelength change layer 600. The protection substrate 700 may act as a back cover of the transparent organic light emitting display device.

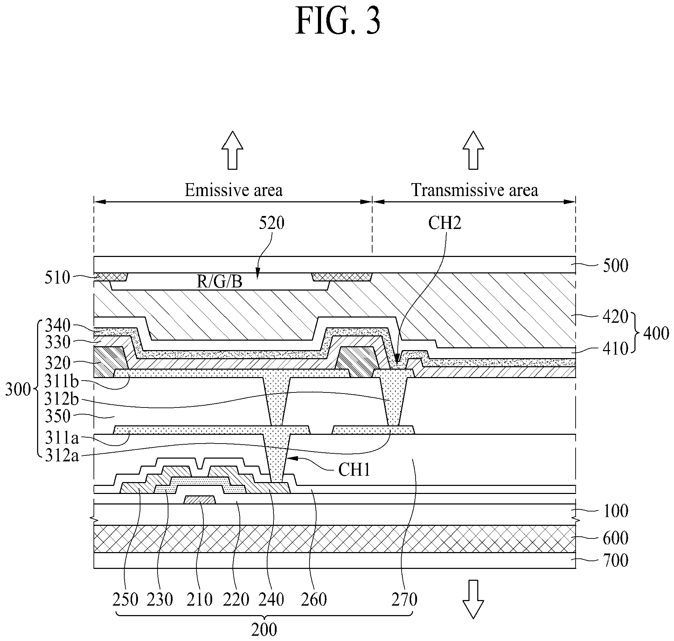

FIG. 3 is a schematic cross-sectional view of a transparent organic light emitting display device according to another embodiment of the present invention. Except that a configuration of an emission device layer 300 is modified, the transparent organic light emitting display device of FIG. 3 is the same as the transparent organic light emitting display device of FIG. 2. Therefore, like reference numerals refer to like elements. Hereinafter, only different elements will be described. As seen in FIG. 3, the emission device layer 300 may include a lower first electrode 311a, an upper first electrode 311b, a lower auxiliary electrode 312a, an upper auxiliary electrode 312b, a bank layer 320, an emission part 330, a second electrode 340, and an interlayer insulation layer 350.

In the embodiment of FIG. 3, a first electrode 311a and 311b may include the lower first electrode 311a and the upper first electrode 311b, an auxiliary electrode 312a and 312b may include the lower auxiliary electrode 312a and the upper auxiliary electrode 312b, and the interlayer insulation layer 350 may be additionally formed between the lower first electrode 311a and the upper first electrode 311b and between the lower auxiliary electrode 312a and the upper auxiliary electrode 312b. For this reason, the embodiment of FIG. 3 differs from the embodiment of FIG. 2. The lower first electrode 311a may be electrically connected to the upper first electrode 311b through a contact hole included in the interlayer insulation layer 350, and the lower auxiliary electrode 312a may be electrically connected to the upper auxiliary electrode 312b through the contact hole included in the interlayer insulation layer 350. In the embodiment of FIG. 3, since an auxiliary electrode 312a and 312b includes the lower auxiliary electrode 312a and the upper auxiliary electrode 312b, a resistance of the second electrode 340 is more effectively lowered without any reduction in pixel area. This will be described below.

As in FIG. 2, in a case where the auxiliary electrode 312 is formed on the same layer as the first electrode 311, if a size of the auxiliary electrode 312 increases for lowering the resistance of the second electrode 340, a size of the first electrode 311 is reduced, and thus, the pixel area is reduced. On the other hand, as in FIG. 3, if the lower auxiliary electrode 312a and the lower first electrode 311a are formed on the same layer and the upper auxiliary electrode 312b and the upper first electrode 311b are formed on the same layer thereon, a size of the area of the lower auxiliary electrode 312a may be increases to lower the resistance of the second electrode 340, and thus, the pixel area is not reduced even if a size of the lower first electrode 311a is reduced. That is, since the lower first electrode 311a connects the source electrode 340
to the upper first electrode 311b, the pixel area is not reduced even if a width of the lower first electrode 311a is reduced. Accordingly, in the embodiment of FIG. 3, a width of lower auxiliary electrode 312a may be increased even without any reduction in pixel area, and in particular, as illustrated, a width of the lower auxiliary electrode 312a may be increased such that the lower auxiliary electrode 312a overlaps with the upper first electrode 311b, thereby more effectively lowering the resistance of the second electrode 340.

In the embodiment of FIG. 3, the interlayer insulation layer 350 may be additionally provided and may include an organic material such as acryl resin, epoxy resin, phenolic resin, polyamide resin, polyimide resin, or the like, and thus, the interlayer insulation layer 350 greatly affects to change the external light which passes through the transmissive area into the yellowish state. That is, a problem where light is transmitted in the yellowish state in the transmissive area further increases in the embodiment of FIG. 3 than the embodiment of FIG. 2, and thus, the wavelength change layer 600 may be designed to absorb relatively more yellowish light.

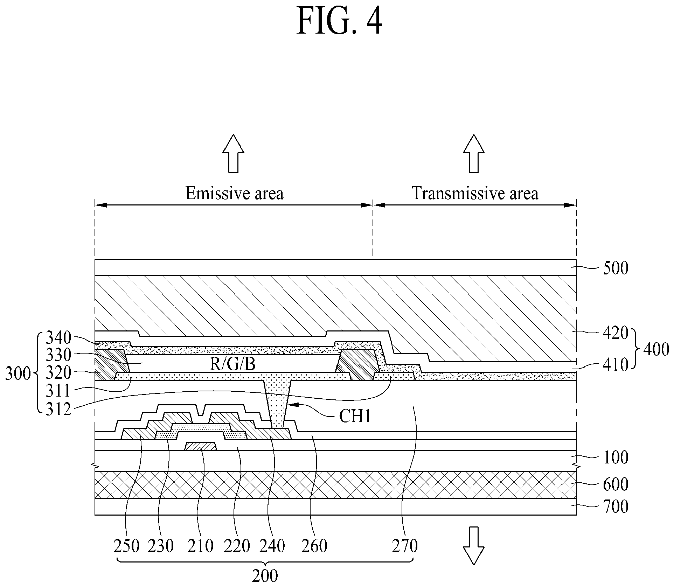

FIG. 4 is a schematic cross-sectional view of a transparent organic light emitting display device according to another embodiment of the present invention. In the transparent organic light emitting display device of FIG. 4, a black matrix 510 and a color filter layer 520 are not disposed on a bottom of a second substrate 500. For this reason, the transparent organic light emitting display device of FIG. 4 differs from the transparent organic light emitting display device of FIG. 2. Therefore, like reference numerals refer to like elements. Hereinafter, only different elements will be described.

According to the embodiment of FIG. 4, an emission part 330 configuring the emission device layer 300 may be configured to emit red (R), green (G), or blue (B) light. That is, the emission part 330 may be patterned for each of a plurality of pixels and may be configured in order for different lights to be emitted from the plurality of pixels, and thus, unlike the above-described structure according to the embodiment of FIG. 2, the black matrix 510 and the color filter layer 520 may not be formed on the bottom of the second substrate 500. Also, unlike the structure according to the embodiment of FIG. 2, since the emission part 330 is patterned for each pixel, a second contact hole CH2 for an electrical connection between an auxiliary electrode 312 and a second electrode 340 may not be provided.

In a structure according to the embodiment of FIG. 4, the emission part 330 may be patterned for each pixel, and thus, unlike the structure according to the embodiment of FIG. 2, the emission part 330 may be disposed in an emissive area but may not be disposed in a transmissive area. Therefore, a problem where light is transmitted in the yellowish state in the transmissive area is further reduced in the embodiment of FIG. 4 than the embodiment of FIG. 2, and thus, the wavelength change layer 600 may be designed to absorb relatively less yellowish light.

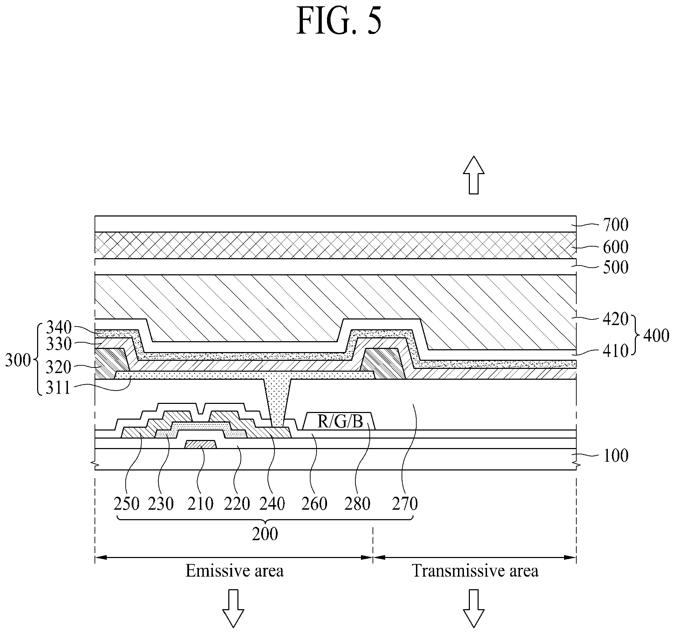

FIG. 5 is a schematic cross-sectional view of a transparent organic light emitting display device according to another embodiment of the present invention. FIGS. 2 to 4 relate to a top emission type transparent organic light emitting display device where light emitted from the emission part 330 is transferred in a direction (i.e., an up direction) toward the second substrate 500. FIG. 5 relates to a bottom emission type transparent organic light emitting display device where light emitted from the emission part 330 is transferred in a direction (i.e., a down direction) toward the first substrate 500.

As seen in FIG. 5, the transparent organic light emitting display device according to another embodiment of the present invention may include an emissive area and a transmissive area. The emissive area and the transmissive area may each include a first substrate 100, a circuit device layer 200, an emission device layer 300, an encapsulation layer 400, a second substrate 500, a wavelength change layer 600, and a protection substrate 700.

The first substrate 100 may be formed of glass or transparent plastic. The circuit device layer 200 may be formed on a top of the first substrate 100. The circuit device layer 200 may include a gate electrode 210, a gate insulation layer 220, a semiconductor layer 230, a source electrode 240, a drain electrode 250, a passivation layer 260, a planarization layer 270, and a color filter layer 280.

Detailed configurations of the gate electrode 210, the gate insulation layer 220, the semiconductor layer 230, the source electrode 240, the drain electrode 250, the passivation layer 260, and the planarization layer 270 may be the same as the above-described embodiments. The color filter layer 280 may be formed on the passivation layer 260. The color filter layer 280 may include a red (R) color filter, a green (G) color filter, and a blue (B) color filter which are pattern-formed in respective pixels. Since white light is emitted from the emission part 330, the color filter layer 280 which is pattern-formed in each of a plurality of pixels may be additionally provided, and thus, a color image may be displayed. However, the present embodiment is not limited thereto. In other embodiments, the color filter layer 280 may be omitted, and instead, the emission part 330 may be pattern-formed to emit red, green, and blue light for each pixel.

The emission device layer 300 may be formed on a top of the circuit device layer 200. The emission device layer 300 may include a first electrode 311, a bank layer 320, an emission part 330, and a second electrode 340. Since the embodiment of FIG. 5 is the bottom emission type, the second electrode 340 may be formed of opaque metal, and thus, an auxiliary electrode (312 in the above-described embodiments) for lowering a resistance of the second electrode 340 may not be provided. In addition, configurations of the first electrode 311, the bank layer 320, the emission part 330, and the second electrode 340 may be the same as the above-described embodiments.

The encapsulation layer 400 may be formed on a top of the emission device layer 300. Likewise with the above-described embodiments, the encapsulation layer 400 may include a passivation layer 410 and a filling layer 420. The second substrate 500 may be formed on a top of the encapsulation layer 400.

The wavelength change layer 600 may be formed on a top of the second substrate 500. The reason is because when the wavelength change layer 600 is disposed on a surface opposite to a display surface displaying an image, a problem where image quality is degraded due to the wavelength change layer 600 is solved. However, the present embodiment is not limited thereto. In other embodiments, the wavelength change layer 600 may be formed on a bottom of the first substrate 100. The protection substrate 700 may be formed on a top of the wavelength change layer 600.

As described above, according to the embodiments of the present invention, even when external light is changed to a yellowish state due to an organic material, the external light is transmitted in a transparent state by the wavelength change layer. Particularly, even when the external light is changed to the yellowish state due to the organic material, the light-absorbing material included in the wavelength change layer absorbs light in the yellowish wavelength range, and thus, the external light is transmitted in the transparent state.

It will be apparent to those skilled in the art that various modifications and variations can be made in the present invention without departing from the scope of the invention. Thus, it is intended that the present invention covers the modifications and variations of this invention provided they are within the scope of the appended claims.

## Claims

1. A transparent organic light emitting display device comprising:
a circuit device layer (200) on a first substrate (100);
an emission device layer (300) on the circuit device layer;
an encapsulation layer (400) on the emission device layer;
a second substrate (500) on the encapsulation layer; and
a wavelength change layer (600) on the first substrate or the second substrate, **characterised in that**
the
wavelength change layer is configured to enable external light to be transmitted in a
transparent state being a state that does not exhibit an apparent colour change in transmitted light;
wherein:
the circuit device layer or the emission device layer comprises an organic material that changes the external light to a yellowish state, and
wherein the wavelength change layer comprises a light-absorbing material only absorbing light in a yellowish wavelength range of 500 nm to 680 nm.

2. The transparent organic light emitting display device of claim 1, wherein: the light-absorbing material comprises a dye including chromophore and auxochrome, the chromophore includes a conjugation structure where a single bond and a double bond are alternately arranged, and
the auxochrome includes an amino group, a hydroxyl group, or an alkyl group.

3. The transparent organic light emitting display device of claim 2, wherein the dye comprises a compound represented by Formula 1: 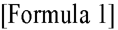 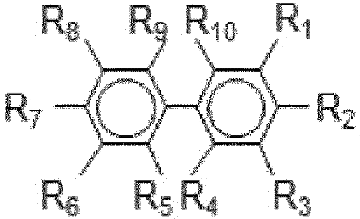 where each of R₁ to R₁₀ is independently selected from a group including hydrogen (H), an alkyl group, a cycloalkyl group, a polycycloalkyl group, a heterocycloalkyl group, an aryl group, an alkaryl group, an aralkyl group, an alkoxy group, an alkenyl group, a hydroxyl group, an amino group, and an alkynyl group.

4. The transparent organic light emitting display device of claim 2, wherein the dye comprises a compound represented by Formula 2: 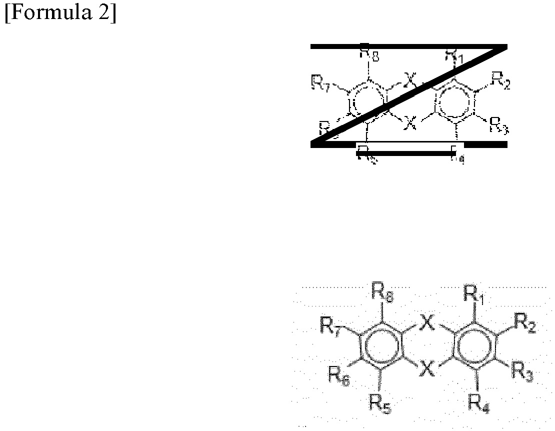 where X includes N-R₉, O, S, and each of R₁ to R₉ is independently selected from a group including hydrogen (H), an alkyl group, a cycloalkyl group, a polycycloalkyl group, a heterocycloalkyl group, an aryl group, an alkaryl group, an aralkyl group, an alkoxy group, an alkenyl group, a hydroxyl group, an amino group, and an alkynyl group.

5. The transparent organic light emitting display device of any one of the preceding claims, wherein the light-absorbing material is present in the wavelength change layer at a concentration of 100 ppm to 5000 ppm.

6. The transparent organic light emitting display device of any preceding claim, wherein the wavelength change layer has a thickness which is within a range of 30 µm to 500 µm.

7. The transparent organic light emitting display device of any preceding claim, wherein the wavelength change layer is disposed on a surface opposite to a display surface displaying an image.

8. The transparent organic light emitting display device of any preceding claim, further comprising a protection substrate,
wherein:
the wavelength change layer comprises transparent resin having an adhesive force, and the protection substrate is adhered to the wavelength change layer by the transparent resin.

9. The transparent organic light emitting display device of any preceding claim, wherein
the emission device layer comprises:
a first electrode;
an auxiliary electrode;
an emission part disposed between the first electrode and the second electrode; and
a second electrode connected to the auxiliary electrode.

10. The transparent organic light emitting display device of claim 9, wherein:
the first electrode includes a lower first electrode and an upper first electrode, and
the auxiliary electrode includes a lower auxiliary electrode and an upper auxiliary electrode.

11. The transparent organic light emitting display device of claim 10, wherein the lower auxiliary electrode overlaps the upper first electrode.

12. The transparent organic light emitting display device any one of claims 9 to 11 wherein the emission part is disposed in an emissive area which emits light, and is not disposed in a transmissive area which transmits external light.

13. The transparent organic light emitting display device of any one of claims 1 to 9, wherein:
the emission device layer includes an emission part, and
the emission part is formed in the emissive area, and is not formed in the transmissive area.

## Patentansprüche

1. Transparente organische lichtemittierende Anzeigevorrichtung, umfassend:
eine Schaltungsvorrichtungsschicht (200) auf einem ersten Substrat (100);
eine Emissionsvorrichtungsschicht (300) auf der Schaltungsvorrichtungsschicht;
eine Verkapselungsschicht (400) auf der Emissionsvorrichtungsschicht;
ein zweites Substrat (500) auf der Verkapselungsschicht und
eine Wellenlängenänderungsschicht (600) auf dem ersten Substrat oder dem zweiten Substrat, **dadurch gekennzeichnet, dass**
die Wellenlängenänderungsschicht dazu ausgestaltet ist, in einem transparenten Zustand externes Licht durchzulassen, wobei es sich bei dem transparenten Zustand um einen Zustand handelt, der keine scheinbare Farbänderung zeigt;
wobei:
die Schaltungsvorrichtungsschicht oder die Emissionsvorrichtungsschicht ein organisches Material umfasst, das das externe Licht zu einem gelblichen Zustand verändert, und
wobei die Wellenlängenänderungsschicht ein Licht absorbierendes Material umfasst, das nur Licht in einem gelblichen Wellenlängenbereich von 500 nm bis 680 nm absorbiert.

2. Transparente organische lichtemittierende Anzeigevorrichtung nach Anspruch 1, wobei das Licht absorbierende Material einen Farbstoff mit einem Chromophor und einem Auxochrom umfasst, wobei der Chromophor eine Konjugationsstruktur mit alternierender Anordnung einer Einfachbindung und einer Doppelbindung enthält und
das Auxochrom eine Aminogruppe, eine Hydroxylgruppe oder eine Alkylgruppe enthält.

3. Transparente organische lichtemittierende Anzeigevorrichtung nach Anspruch 2, wobei der Farbstoff eine durch Formel 1 wiedergegebene Verbindung umfasst: 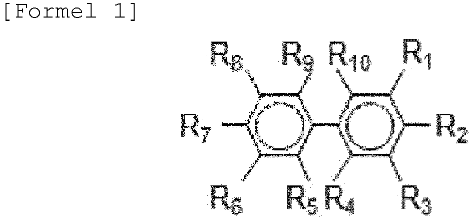 wobei R₁ bis R₁₀ jeweils unabhängig aus der Gruppe enthaltend Wasserstoff (H), eine Alkylgruppe, eine Cycloalkylgruppe, eine Polycycloalkylgruppe, eine Heterocycloalkylgruppe, eine Arylgruppe, eine Alkylarylgruppe, eine Aralkylgruppe, eine Alkoxygruppe, eine Alkenylgruppe, eine Hydroxylgruppe, eine Aminogruppe und eine Alkinylgruppe ausgewählt sind.

4. Transparente organische lichtemittierende Anzeigevorrichtung nach Anspruch 2, wobei der Farbstoff eine durch Formel 2 wiedergegebene Verbindung umfasst: 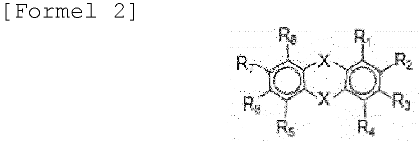 wobei X N-R₉, O oder S einschließt und R₁ bis R₉ jeweils unabhängig aus der Gruppe enthaltend Wasserstoff (H), eine Alkylgruppe, eine Cycloalkylgruppe, eine Polycycloalkylgruppe, eine Heterocycloalkylgruppe, eine Arylgruppe, eine Alkylarylgruppe, eine Aralkylgruppe, eine Alkoxygruppe, eine Alkenylgruppe, eine Hydroxylgruppe, eine Aminogruppe und eine Alkinylgruppe ausgewählt sind.

5. Transparente organische lichtemittierende Anzeigevorrichtung nach einem der vorhergehenden Ansprüche, wobei das Licht absorbierende Material in der Wellenlängenänderungsschicht in einer Konzentration von 100 ppm bis 5000 ppm vorliegt.

6. Transparente organische lichtemittierende Anzeigevorrichtung nach einem der vorhergehenden Ansprüche, wobei die Wellenlängenänderungsschicht eine Dicke im Bereich von 30 µm bis 500 µm aufweist.

7. Transparente organische lichtemittierende Anzeigevorrichtung nach einem der vorhergehenden Ansprüche, wobei die Wellenlängenänderungsschicht auf einer Oberfläche angeordnet ist, die einer ein Bild anzeigenden Anzeigeoberfläche gegenüberliegt.

8. Transparente organische lichtemittierende Anzeigevorrichtung nach einem der vorhergehenden Ansprüche, ferner umfassend ein Schutzsubstrat, wobei
die Wellenlängenänderungsschicht transparentes Harz mit einer Haftkraft umfasst und das Schutzsubstrat über das transparente Harz haftend auf der Wellenlängenänderungsschicht aufgebracht ist.

9. Transparente organische lichtemittierende Anzeigevorrichtung nach einem der vorhergehenden Ansprüche, wobei die Emissionsvorrichtungsschicht Folgendes umfasst:
eine erste Elektrode;
eine Hilfselektrode;
einen zwischen der ersten Elektrode und der zweiten Elektrode angeordneten Emissionsteil und eine zweite Elektrode, die mit der Hilfselektrode verbunden ist.

10. Transparente organische lichtemittierende Anzeigevorrichtung nach Anspruch 9, wobei:
die erste Elektrode eine untere erste Elektrode und eine obere erste Elektrode einschließt und
die Hilfselektrode eine untere Hilfselektrode und eine obere Hilfselektrode einschließt.

11. Transparente organische lichtemittierende Anzeigevorrichtung nach Anspruch 10, wobei die untere Hilfselektrode mit der oberen ersten Elektrode überlappt.

12. Transparente organische lichtemittierende Anzeigevorrichtung nach einem der Ansprüche 9 bis 11, wobei der Emissionsteil in einem Licht emittierenden Emissionsbereich angeordnet ist und nicht in einem durchlässigen Bereich, der externes Licht durchlässt, angeordnet ist.

13. Transparente organische lichtemittierende Anzeigevorrichtung nach einem der Ansprüche 1 bis 9, wobei:
die Emissionsvorrichtungsschicht einen Emissionsteil einschließt und
der Emissionsteil in dem Emissionsbereich angeordnet ist und nicht in dem durchlässigen Bereich angeordnet ist.

## Revendications

1. Dispositif d'affichage électroluminescent organique transparent comprenant :
une couche de dispositif de circuit (200) sur un premier substrat (100) ;
une couche de dispositif d'émission (300) sur la couche de dispositif de circuit ;
une couche d'encapsulation (400) sur la couche de dispositif d'émission ;
un deuxième substrat (500) sur la couche d'encapsulation ; et
une couche de changement de longueur d'onde (600) sur le premier substrat ou le deuxième substrat,
**caractérisé en ce que**
la couche de changement de longueur d'onde est configurée pour permettre à une lumière externe d'être transmise dans un état transparent étant un état qui ne présente pas un changement de couleur apparent de la lumière transmise ;
dans lequel :
la couche de dispositif de circuit ou la couche de dispositif d'émission comprend un organique matériau qui change la lumière externe dans un état jaunâtre, et
dans lequel la couche de changement de longueur d'onde comprend un matériau absorbant la lumière qui absorbe la lumière uniquement dans une plage de longueur d'onde jaunâtre de 500 nm à 680 nm.

2. Dispositif d'affichage électroluminescent organique transparent selon la revendication 1, dans lequel : le matériau absorbant la lumière comprend un colorant comprenant un chromophore et un auxochrome, le chromophore comprend une structure de conjugaison où une simple liaison et une double liaison sont agencées de façon alternée, et
l'auxochrome comprend un groupe amino, un groupe hydroxyle ou un groupe alkyle.

3. Dispositif d'affichage électroluminescent organique transparent selon la revendication 2, dans lequel le colorant comprend un composé représenté par la formule 1 : 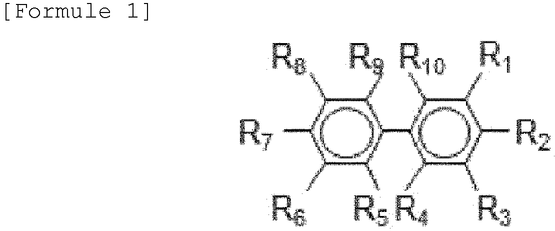 où chacun de R₁ à R₁₀ est indépendamment choisi parmi un groupe comprenant hydrogène (H), un groupe alkyle, un groupe cycloalkyle, un groupe polycycloalkyle, un groupe hétérocycloalkyle, un groupe aryle, un groupe alkaryle, un groupe aralkyle, un groupe alcoxy, un groupe alcényle, un groupe hydroxyle, un groupe amino et un groupe alcynyle.

4. Dispositif d'affichage électroluminescent organique transparent selon la revendication 2, dans lequel le colorant comprend un composé représenté par la formule 2 : 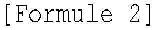 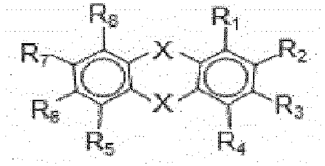 où X comprend N-R₉, O ou S, et chacun de R₁ à R₈ est indépendamment choisi parmi un groupe comprenant hydrogène (H), un groupe alkyle, un groupe cycloalkyle, un groupe polycycloalkyle, un groupe hétérocycloalkyle, un groupe aryle, un groupe alkaryle, un groupe aralkyle, un groupe alcoxy, un groupe alcényle, un groupe hydroxyle, un groupe amino, et un groupe alcynyle.

5. Dispositif d'affichage électroluminescent organique transparent selon l'une quelconque des revendications précédentes,
dans lequel le matériau absorbant la lumière est présent dans la couche de changement de longueur d'onde à une concentration de 100 ppm à 5000 ppm.

6. Dispositif d'affichage électroluminescent organique transparent selon l'une quelconque des revendications précédentes, dans lequel la couche de changement de longueur d'onde a une épaisseur qui est dans une plage de 30 µm à 500 µm.

7. Dispositif d'affichage électroluminescent organique transparent selon l'une quelconque des revendications précédentes, dans lequel la couche de changement de longueur d'onde est disposée sur une surface opposée à une surface d'affichage affichant une image.

8. Dispositif d'affichage électroluminescent organique transparent selon l'une quelconque des revendications précédentes, comprenant en outre un substrat de protection,
dans lequel :
la couche de changement de longueur d'onde comprend une résine transparente ayant une force d'adhérence, et le substrat de protection est collé à la couche de changement de longueur d'onde par la résine transparente.

9. Dispositif d'affichage électroluminescent organique transparent selon l'une quelconque des revendications précédentes, dans lequel
la couche de dispositif d'émission comprend :
une première électrode ;
une électrode auxiliaire ;
une partie d'émission disposée entre la première électrode et la deuxième électrode ; et
une deuxième électrode connectée à l'électrode auxiliaire.

10. Dispositif d'affichage électroluminescent organique transparent selon la revendication 9, dans lequel :
la première électrode comprend une première électrode inférieure et une première électrode supérieure, et
l'électrode auxiliaire comprend une électrode auxiliaire inférieure et une électrode auxiliaire supérieure.

11. Dispositif d'affichage électroluminescent organique transparent selon la revendication 10, dans lequel l'électrode auxiliaire inférieure chevauche la première électrode supérieure.

12. Dispositif d'affichage électroluminescent organique transparent l'une quelconque des revendications 9 à 11 dans lequel la partie d'émission est disposée dans une zone d'émission qui émet de la lumière, et n'est pas disposée dans une zone de transmission qui transmet la lumière externe.

13. Dispositif d'affichage électroluminescent organique transparent selon l'une quelconque des revendications 1 à 9, dans lequel :
la couche de dispositif d'émission comprend une partie d'émission, et
la partie d'émission est formée dans la zone d'émission, et n'est pas formée dans la zone de transmission.
